# EUROPEAN PATENT SPECIFICATION

(11) **EP 0 589 499 B1**
(45) Date of publication and mention of the grant of the patent: **07.04.1999**
(21) Application number: 93202338.5
(22) Date of filing: 09.08.1993
(51) Int. Cl.: G06F 13/42, G11C 5/06

(54) **A multistation communication bus system, and a master station and a slave station for use in such system**
Mehrstationskommunikationsbussystem, sowie eine Master-Station und eine Slave-Station für den Einsatz in einem solchen System
Système omnibus de communication à stations multiples ainsi que station maître et station esclave destinées à être utilisées dans un tel système

(30) Priority: 12.08.1992 EP 92202485
(43) Date of publication of application: 30.03.1994
(73) Proprietor: Koninklijke Philips Electronics N.V., 5621 BA Eindhoven (NL)
(72) Inventor: Lokhoff, Gerardus Cornelis Petrus, NL-5656 AA Eindhoven (NL)
(74) Representative: Groenendaal, Antonius Wilhelmus Maria

(56) References cited:
- EP-A- 0 051 332
- EP-A- 0 159 941
- GB-A- 2 222 921
- IEEE JOURNAL OF SOLID-STATE CIRCUITS vol. SC-16, no. 3 , June 1981 , NEW YORK US pages 190 - 194 G.MEUSBURGER '1.5V 1K-CMOS-RAM with only 8 pins'

## Description

### FIELD OF THE INVENTION

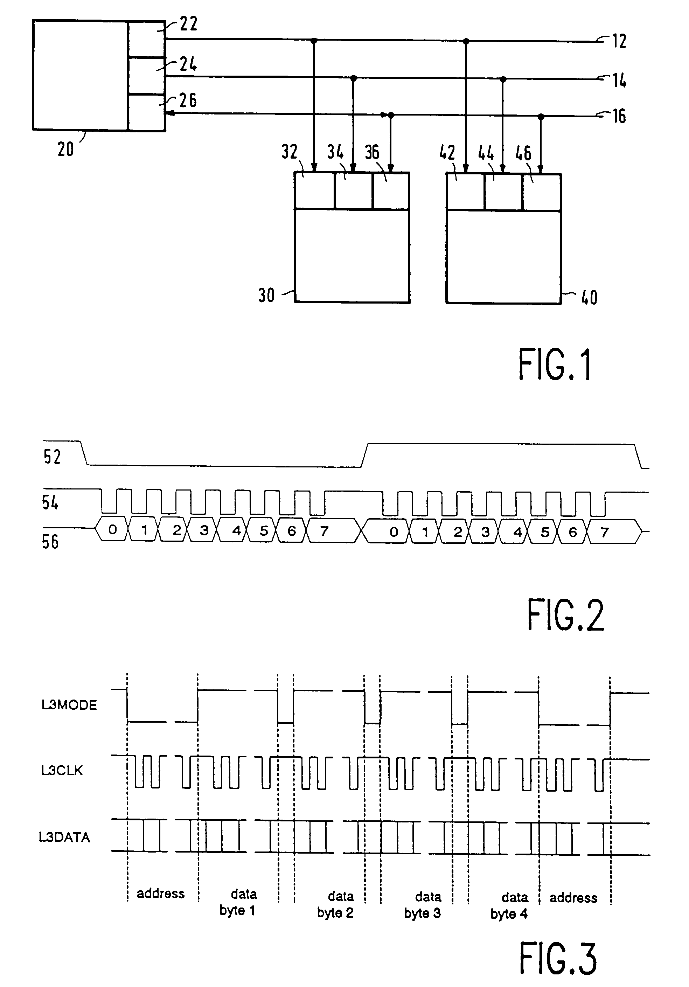

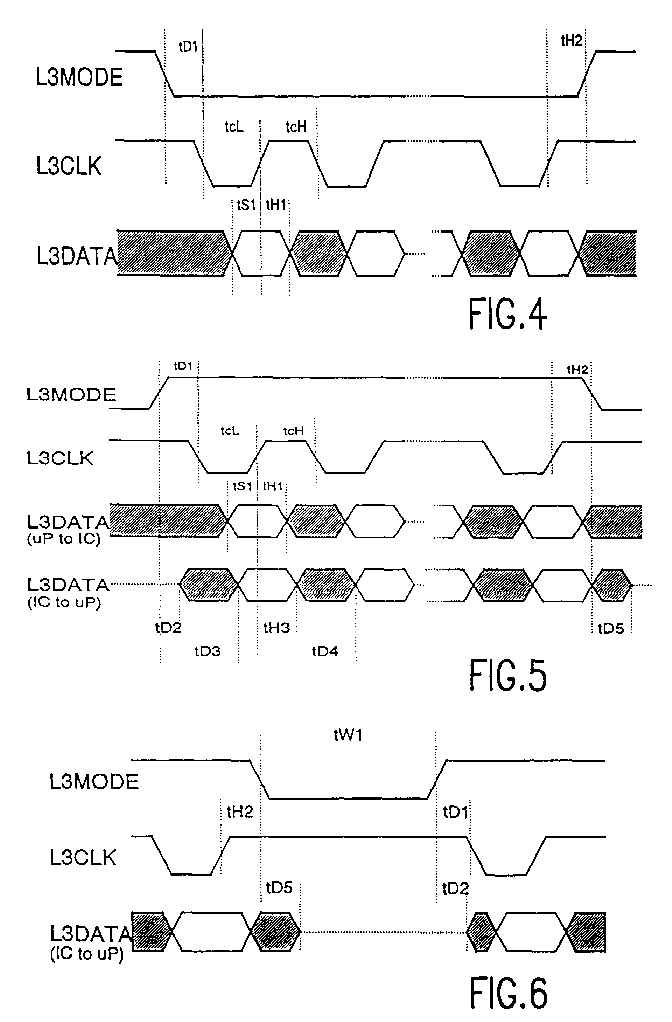

The invention relates to a multistation communication bus system accommodating one master station and a plurality of slave stations, said master station being arranged for separately transmitting clock signals, information bit group signals, and indication signals on respective separate wires, each indication signal identifying an actual information bit group as representing either address information or data information. Such a system has been described in "Serial techniques expand your options for microC peripherals" by Mr. Naji Naufel, EDN February 18, 1988 p. 199-204, in particular Fig. 4, referring to the IDENT line of the Intermetall line of peripherals. Fig. 2 of the same article, however, states that these same peripherals need part of a parallel port for control purposes. There is a growing need for narrow serial bus systems to communicate with peripherals that, although having sophisticated internal functionality, are less versatile viz à viz a remote master station.

### SUMMARY OF THE INVENTION

Accordingly, amongst other things, it is an object of the present invention to provide a system of this kind that provides a straightforward communication protocol, and wherein in particular the message format should be short, as calculated in the number of bytes, whilst allowing for bidirectional transfer, and also for a limited set of control operations, inclusive of reset of the peripheral bus interface. Now, according to one of its aspects, the invention as set forth in claim 1 is characterized in that such address information bit group also comprises control bits next to operational address bits, said slave stations each being arranged for recognizing:
* at least one particular respective address as their own address,
* respective values of said control bits as mandating a subsequent data transfer direction with respect tot an addressed slave, and
* one particular operational address as an interface reset control signal.
A particular advantage of this technology is that transition between an address bit group and a data bit group can be detected without recourse to a bit counter. An additional advantage of resetting the interface the bus is that the bus thereupon is freed from the above protocol, whereby execution of a different and incompatible protocol becomes feasible.

It should be noted that "1.5 V 1 K-CMOS-RAM with only 8 pins", IEEE Journal of solid-state circuits, Vol. SC-16, No. 3, June 1981, pages 190 - 194 discloses a 6-wire serial memory interface with four bi-directional data wires and two control wires. A transmission of a fixed length 4-bit chip select code (one block of 4 bits in parallel) and an 8-bit memory address (a sequence of two blocks of 4 bits in parallel) is followed by a transmission of a 4-bit parallel data block via the same data wires. No indication signal is used for differentiating between the two types of information. One of the control wires is dedicated to indicate either a read or a write operation. No control bits indicating a data transfer direction are transferred via the data wire. The other control wire provides a clock signal. A dedicated chip select code (1111) selects all RAM's on the bus, where after an arbitrary 8-bit address the transfer of a data value (0000) will load all memory cells with zeros.

EP-A 0 159 941 discloses a bi-directional serial computer bus using four wires. A clock line is used for transferring a clock signal. A frame line is used for indicating a frame. A sync line is used for indicating asynchronous information fields within a frame. A signal line is used for propagating data, address and control information in a bi-directional manner. After a fixed-length address information has been transmitted via the signal line, transmission of data information via the same signal line starts without using an indication signal for differentiating between the two types of information. The control information specifies the direction of data transfer. No resetting of the system via the bus is disclosed.

The invention also relates to a master station for use in such system and to a slave unit for use in such system.

Advantageously, said address bit group comprises a system address bit subgroup as distinct from a device address bit subgroup. This allows easy definition of the various peripheral/slave station addresses in a multi-manufacturer environment.

Advantageously, said master station is arranged for driving said indication signal to the address identifying value for signalling a "halt" mode. This is a straightforward signal organization for making it clear to any slave station that the master station will refrain from communication for the time being.

Advantageously, said system is provided for executing an address programming mode through transfer of a secondary address identification code. The same organization as provided for the standard communication may with a slight extension be used for such address programming.

Advantageously, said system is arranged for through said interface reset control signal freeing said bus for thereby accommodating execution of a different and incompatible bus protocol. Especially in a multimanufacturer environment, various other, non-conforming bus protocols may be implemented. Now, these various protocol definitions may share their respective hardware transfer media for so lowering costs.

In particular, the invention relates to a master station having first bus wire attachment means for outputting clock signals, second bus wire attachment means for communicating information bit group signals, and third bus wire attachment means for outputting indication signals, each indication signal identifying an actual information bit group as representing either address information or data information, characterized in that said second bus wire attachment means are arranged to output a plurality of different addresses inclusive of at least one operational address bit as an interface reset control signal, and in that said second bus wire attachment means are arranged for within an address bit group inserting at least two control bits for with respective values thereof mandating a subsequent data transfer direction with respect to an addressed slave. At a moderate cost level, this allows for high transfer speed at appropriate flexibility.

In particular, the invention relates to a slave station having fourth bus wire attachment means for receiving said clock signals, fifth bus wire attachment means for communicating information bit group signals, and sixth bus wire attachment means for receiving indication signals and through the value of such indication signal discriminating an actual bit group received as representing either address information or data information, said fifth bus wire attachment means being responsive to said discriminating for when address information being arranged to:
* recognizing at least one particular respective address as its own address;
* within an address information representing bit group recognizing respective values of non-address control bits as mandating a subsequent data transfer direction with respect said fifth bus wire attachment means. In mirroring the master station's features, the slave station is inexpensive and adequate and extremely useful in low-level devices such as consumer electronics for audio/video entertainment, especially, with an eye on low cost.

Various advantageous aspects are recited in dependent Claims.

### BRIEF DESCRIPTION OF THE DRAWINGS

These and other advantages will be explained more in detail with respect to the Figures that show a preferred embodiment, and in particular
Figure 1 a system according to the invention;
Figure 2 an elementry bus signal arrangement;
Figure 3 a four byte transfer diagram;
Figure 4 an addressing time diagram;
Figure 5 a data transfer time diagram;
Figure 6 a halt mode time diagram;
Figure 7 a diagrammatic interactivity between subsystems in master station and slave station.

### DETAILED DESCRIPTION OF A PREFERRED EMBODIMENT

The main purpose of the new interface definition is to define a protocol that allows for the transfer of control information and operational details between a microcontroller (µC) and a number of slave devices, at a rate that exceeds other common interfaces, but with a sufficient low complexity for application in consumer products, such as digital audio tape recorders, video recorders, high-fi audio apparatus, and others. It should be noted that the interface is intended for use in a single apparatus, preferably restricted to a single printed circuit board. The new interface requires three signal lines (apart from a return "ground") between the microcontroller and the slave devices (from this the name "L3" is derived). These three lines are common to all IC's connected to the bus: L3MODE, L3DATA and L3CLK. L3MODE and L3CLK are always driven by the microcontroller, L3DATA is bidirectional:

| signal name | microcontroller | slave device |
|---|---|---|
| L3MODE | output | input |
| L3CLK | output | input |
| L3DATA | output/input | input/output |

L3DATA will carry the information to be transferred. L3CLK is the bit clock to which the information transfer will be synchronized. L3MODE is used for the identification of the operation mode.

All slave devices in the system can be addressed using a 6 bit address. This allows for up to 63 different slave devices, because the all "0" address is reserved for special purposes. In addition it is possible to extend the number of addressable devices using "extended addressing", as explained hereinafter. In operation two modes can be identified: addressing mode (AM) and data mode (DM).

Figure 1 is a block diagram of a communication bus system according to the invention. The bus consists of three wires 12, 14, 16 or lines, according to a non-specified physical realization. The system has three stations, master microcontroller 20, and slave stations 30, 40. The latter may be microcontrollers as well, but generally, they are realized as special purpose blocks such as application specific integrated circuits (ASICs). Line 12 is a mode line, with mode line interface circuits 22, 32, 42 in the respective stations. Likewise, clock line 14 has clock interface circuits 24, 34, 44 and data 16 has data interface circuits 26, 36, 46. Data transfer is either from the master or towards the master, but never between two slaves. Clock and mode is always transferred from the master to one or more slaves. Construction of the interfacing circuitry is straightforward once the bus parameters have been defined. For brevity, no further details are presented here.

Figure 2 shows various signal shapes occurring in the arrangement of Figure 1. the shapes of the various signals have been indicated in a global manner. As regards more precise timing requirements, reference is made to Figures 4 to 6 hereinafter. Now trace 52 shows the mode indication bit; at left, the addressing mode prevails (mode signal low), at right, the data mode (mode signal high). If the master is not in operation with respect to the bus (it may then execute internal tasks) the mode signal is inconsequential. During addressing mode a single 8-bit byte is sent by the microcontroller (station 20 in Figure 1). This byte consists of two leading data operation mode (DOM) bits and 6 operational address (OA) bits. Each of the slave devices evaluates the operational address. Only the device that has been issued the same operational address will become active during the following data mode. The operation to be executed during the data mode is indicated by the two data operation mode bits. If required, a slave station may recognize two or more different address contents as its "own address".

During data mode, information is transferred between microcontroller and slave device. The transfer direction may be from microcontroller to slave ("write") or from slave to microcontroller ("read"). However, during one data mode the transfer direction cannot change.

In order to start an addressing mode the microcontroller will make the mode line low. The clock line is lowered 8 times and the data line will carry 8 bits, one for each clock pulse. The addressing mode is ended by making the mode line high.

The meaning of the bits on the data line is: bits 0 & 1 are the data operation mode (DOM) bits that indicate the nature of the subsequent data transfer. Each slave device may have its own allocation of operation modes to the four possible codes of these bits. However, for new designs the preferred allocations are:

| DOM1 / 0 | Function | Remarks |
|---|---|---|
| 0 / 0 | data from µC to IC | general purpose data transfer |
| 0 / 1 | data from IC to µC | general purpose data transfer |
| 1 / 1 | control from µC to IC | e.g. register selection for data transfer |
| 1 / 1 | status from IC to µC | short device status message |

Bits 2 to 7 act as 6 bit operational IC address, with bit 7 as MSB and bit 2 as LSB. Bits 7, 6 and 5 act as system identification and bits 4, 3 and 2 as identification of the device within the system.
The following is a list of operational addresses:

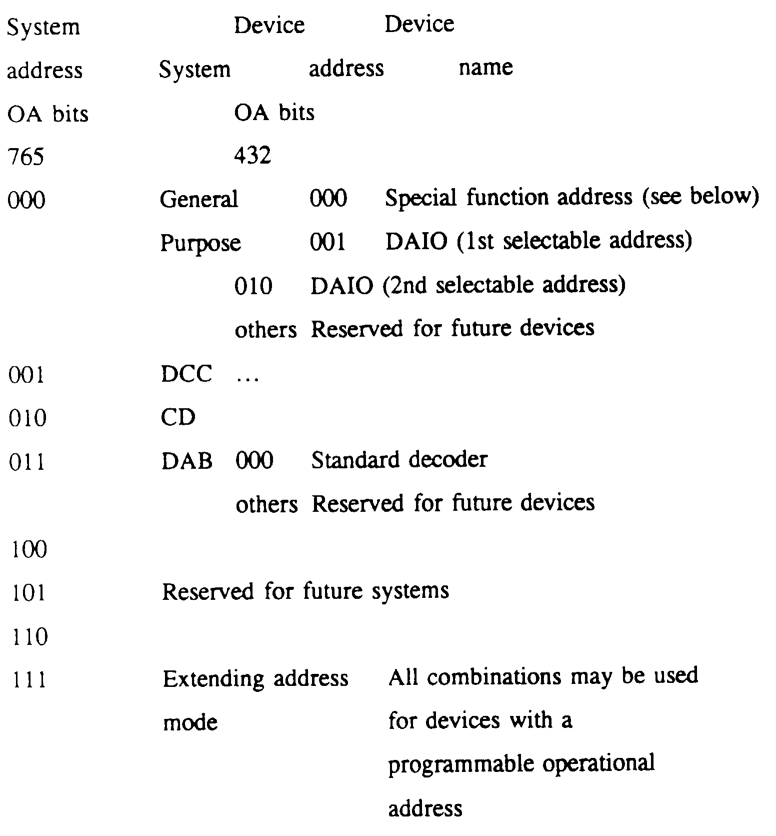

The special function address (000000) is used for the L3 device reset, as well as for the declaration and invalidation of the extended addressing. Both will be explained herebelow.

In the data mode the microcontroller sends information to or receives information from the selected device. During data transfer the L3MODE line is HIGH. The L3CLK line is lowered 8 times during which the L3DATA line carries 8 bits. The information is presented LSB first and remains stable during the LOW phase of the L3CLK signal. The preferred basic data transfer is an 8 bit byte. Some implementations may use a basic unit of 16 bits, transferred as 2 bytes, with the most significant byte presented first.

### HALT MODE

In between units the L3MODE line will be driven LOW by the microprocessor to indicate the completion of a basic unit transfer: this is called "halt mode" (HM). During halt mode the L3CLK line remains HIGH (to distinguish it from an addressing mode). The halt mode allows an implementation of an interface module without a bit counter. However, an implementation using a bit counter in the interface module may allow for the L3MODE line to be kept HIGH in between units (not using the halt mode).

Figure 3 shows a diagram of a four byte information transfer. First, the mode signal is low during eight clock periods, thereby allowing the transfer of two control bits and six address bits. Next, the mode signal is high during each of four sequences of eight clock pulses each. This allows for the transfer of four bytes. Between two contiguous byte transfer periods the mode signal becomes low for a short interval. This allows the slave station to reset as a countermeasure against spurious spikes, etcetera superposed on the clock that could cause pseudo data bits to be considered transferred. At the end of the transfer of the four bytes, the mode bit goes low to signal a subsequent address transfer operation. The mode bit remains low after reset, etcetera, thereby making a bit counter in the slave stations superfluous.

### DEVICE INTERFACE RESET

If the microcontroller sends an operational address "000000" with DOM1 and DOM0 also equal to "0" this indicates that none of the L3 interface devices is allowed to communicate with the microcontroller during the following data mode. This enables a different application of the L3CLK and L3DATA lines as the L3 devices will not interfere with any communication on these lines as long as L3MODE remains High (e.g. the L3CLK and L3DATA lines are normally connected to USART circuits in the microcontrollers which allow for convenient communication between microcontrollers).

Any addressing mode with a valid L3 operational address will re-enable the communication with the corresponding device. Other devices with a fixed operational address ("Primary L3 devices") will then react with a device reset condition condition regardless of the state of DOM1 and DOM0.

Devices with a programmable operational address can only be put in the interface reset condition if the DOM1 and DOM0 bits are "0". Other combinations of DOM1 and DOM0 initiate data transfers for "extended addressing".

### EXTENDED ADDRESSING

L3 devices with a programmable address can be informed of their operational address using a special data transfer. For the programming of the operational address of an L3 device with a "secondary L3 identification code" the following action is required:
First the microcontroller must issue an L3 operational address "000000" (special function address) with DOM1 = "0" and DOM0 = "1". This combination defines the operational address declaration operation. Next, the microcontroller will start a data transfer mode in which it first sends the secondary L3 identification code for the device that is to be issued an operational address, followed by a byte containing the operational address (the DOM bits in this byte are don't cares).

A secondary L3 identification code is unique for any design. Special designs may have a range of identification codes, one of which can be selected by a hardware solution, to enable the connection of more than one device of the same design to the L3 interface. It is also possible to use separate L3MODE lines for multiple circuits of the same design, but the same L3 identification code (this also enables "parallel programming" of these devices).
Bit 0 of any identification code byte will indicate whether or not a additional byte follows:
- 0 -: no additional byte as part of the identification code;
- 1 -: additional byte follows.
In so doing, the supplemental address information may in effect render the address length unlimited, so that the number of secondary L3 identification codes is -in theory- unlimited.

The operational address for the programmable device is preferable in the range 111000 - 111111. However, it is possible in a given application to issue any operational address that is not used to address primary L3 devices or other secondary L3 devices. Example: bits are shown in the order they appear on L3DATA (bit 0 first, bit 7 last).

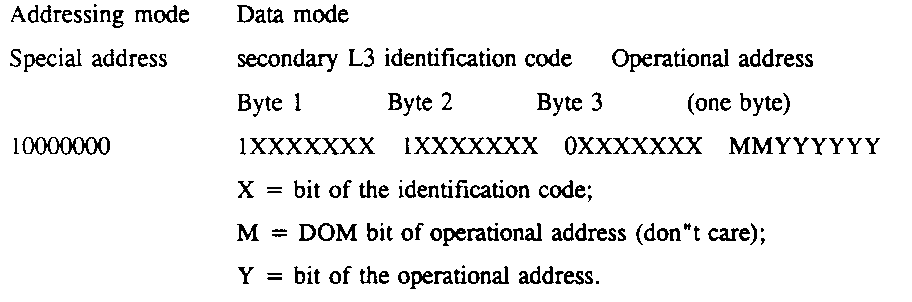

### OPERATIONAL ADDRESS INVALIDATION

In order to re-allocate an operational address that has been allocated to a secondary L3 device it is possible to invalidate an operational address:
First the microcontroller must issue an L3 operational address "000000" (special function address) with DOM1 = "1" and DOM0 - - "0". This combination defines the operational address invalidation operation.
Next the microcontroller will start a data transfer mode in which it only sends the secondary L3 identification code for the device that will no longer be addressed. From this moment on the device will not be able to communicate with the microcontroller until it is issued a new operational address by an OA (Operational Address) declaration (it will then enter a "device interface reset" condition).

A data transfer starts when the microcontroller sends an address on the bus. All IC's will evaluate this address, but only the IC addressed will be an active partner for the microcontroller in the following data transfer mode.

During the data transfer mode, bytes will be sent from or to the microcontroller. In this example the L3MODE line is made low ("halt mode") in between byte transfers. This is the default operation, although some IC's may allow the L3MODE line to be kept high.

After the data transfer the microcontroller need not send a new address until a new data transfer is necessary. Alternatively it may also send the "special address" 000000 to indicate the end of the data transfer operation.

Figure 4 shows an address timing diagram, with the following requirements:

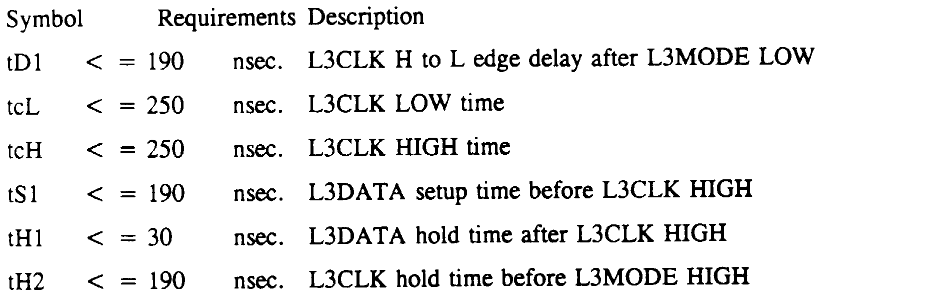

Figure 5 shows a data timing diagram, with the following requirements:

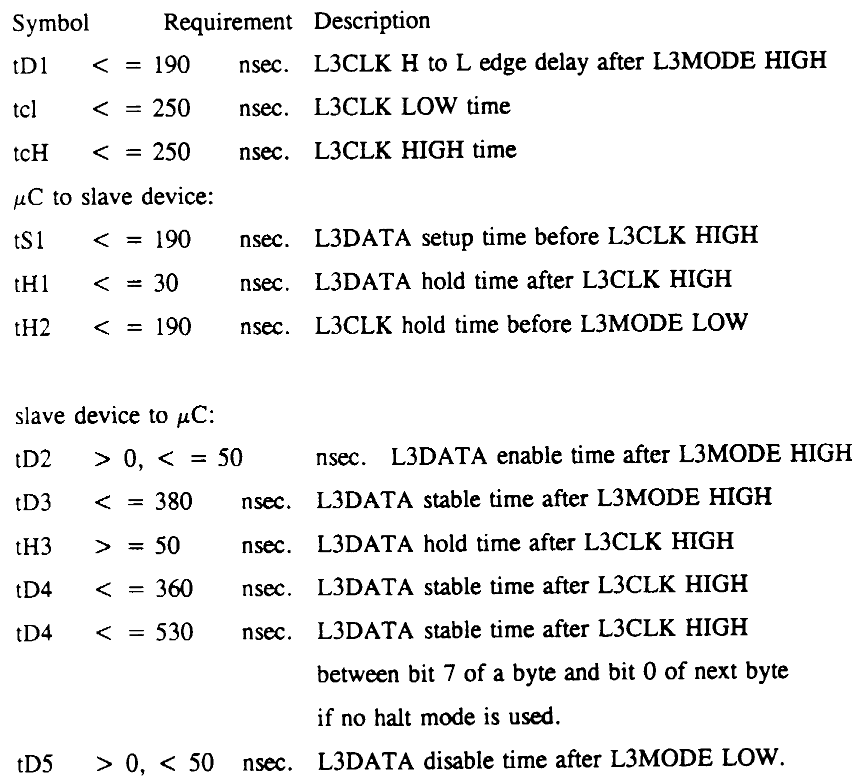

Figure 6 shows a halt mode timing diagram, with the following requirements:

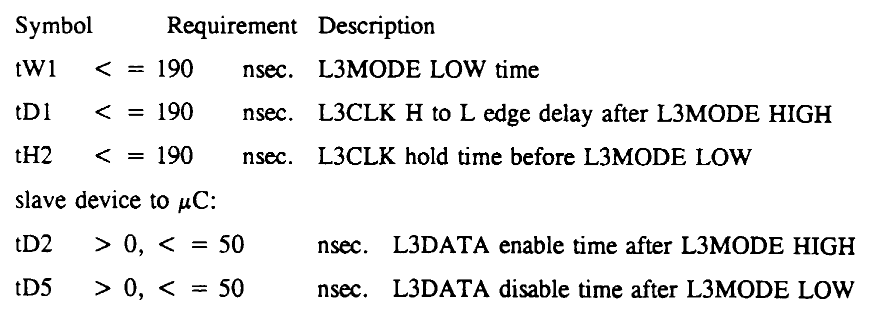

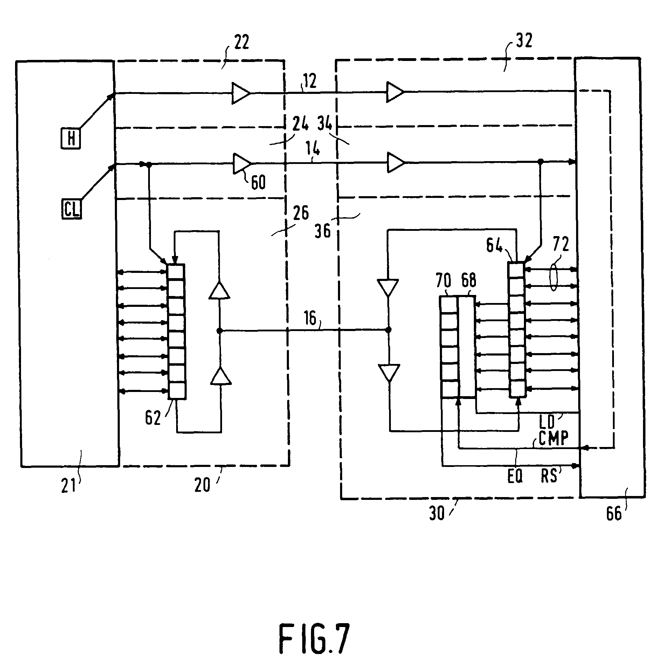

Figure 7 shows the diagrammatic interactivity between various subsystems in master station and slave station. Various reference numerals corresponding to those in Figure 1. In master station 20 there is a processor nucleus 21, a clock generator CI, a halt signal generator H. The clock mode and information lines have been buffered both in the master station and in the slave station, such as by element 60. The information line has been buffered bidirectionally, and the transfer direction is controlled through selective driving of the buffers from the local stations nucleus along control lines not shown. The master station's attachment to the information wire comprises register 62 (8 bits) that features both parallel and serial I/O and as regards serial transfer is clocked by clock wire attachment block 24. The slave station comprises a similar 8-bit register 64 that communicates with slave station nucleus 66. Furthermore, address comparator 68 and preset address register 70 are activated through a "compare" signal CMP that is derived from the mode signal (at the end of the addressing mode) and through a load signal LD from the nucleus for loading a new address if applicable. Upon equality, signal EQ to the nucleus indicates that the next byte space is intended to transfer of an information bit group, the two control bits (72) indicating the transfer direction. During the transfer, the comparator is disabled, but if applicable, a new identifier may be loaded. In similar way, longer addresses are feasible through multiple byte address loading. The comparison that would upon equality produce a reset signal has been indicated along the equality wire - this could in consequence be multiple. The functionality of nucleus 66 is not described further, its character does not pertain to the invention proper.

## Claims

1. A multistation communication bus system accommodating one master station (20) and a plurality of slave stations (30, 40), said master station (20) being arranged for separately transmitting clock signals (14), information bit group signals (16), and indication signals (12) on respective three separate wires, each indication signal (12) identifying an actual information bit group as representing either address information or data information, characterized in that such address information bit group also comprises control bits next to operational address bits, said slave stations each being arranged for recognizing:
* at least one particular respective address as their own address,
* respective values of said control bits as mandating a subsequent data transfer direction with respect to an addressed slave, and
* one particular operational address as an interface reset control signal.

2. A system as claimed in Claim 1, wherein said address bit group comprises a system address bit subgroup as distinct from a device address bit subgroup.

3. A system as claimed in Claim 1 or 2, wherein said master station (20) is arranged for driving said indication signal to the address identifying value for signalling a "halt" mode.

4. A system as claimed in Claim 1, 2 or 3, and being provided for executing an address programming mode through transfer of a secondary address identification code.

5. A system as claimed in any of Claims 1 to 4, and being arranged for through said interface reset control signal freeing said bus for thereby accommodating execution of a different and incompatible bus protocol.

6. A system as claimed in any of Claims 1 to 5, and having two identically addressable slave stations, that have clock signal wire and information bit group wire in common, but respective separate indication wires separately attached to said master station.

7. A system as claimed in any of Claims 1 to 6, wherein in an address information bit group at least one bit signals that a subsequent information bit group contains supplemental address information.

8. A master station for use in a system as claimed in any of Claims 1 to 5, having first bus wire attachment means (24) for outputting clock signals, second bus wire attachment means (62) for communicating information bit group signals, and third bus wire attachment means for outputting indication signals, each indication signal identifying an actual information bit group as representing either address information or data information, characterized in that said second bus wire attachment means are arranged to output a plurality of different addresses inclusive of at least one operational address bit as an interface reset control signal, and in that said second bus wire attachment means are arranged for within an address bit group inserting at least two control bits for with respective values thereof mandating a subsequent data transfer direction with respect to an addressed slave.

9. A master station (20) as claimed in Claim 6 and having "halt" control means connected to said third bus wire attachment means for through its address information identifying value of said indication signals signalling a "halt" mode.

10. A slave station (30) for use in a system as claimed in any of Claims 1 to 5 or with a master station (20) as claimed in Claim 8 or 9, and having fourth bus wire attachment means for receiving said clock signals, fifth bus wire attachment means for communicating information bit group signals, and sixth bus wire attachment means for receiving indication signals and through the value of such indication signal discriminating an actual bit group received as representing either address information or data information, said fifth bus wire attachment means being responsive to said discriminating for when address information being arranged to:
* recognizing at least one particular rcspective address as its own address;
* within an address information representing bit group recognizing respective values of non-address control bits as mandating a subsequent data transfer direction with respect said fifth bus wire attachment means.

11. A slave station (30) as claimed in Claim 10, wherein said fifth bus wire attachment means are responsive for receiving address information and in particular a secondary address identification code for subsequently driving said slave station in an address programming mode.

12. A slave station (30) as claimed in Claim 10 or 11, wherein said sixth bus wire attachment means are responsive to said address identifying value for under absence of clock pulses on said fourth bus wire attachment means driving the slave station in question to a "halt" mode.

13. A slave station (30) as claimed in Claim 10, 11 or 12 and arranged for operational address programmability, wherein said fifth bus wire attachment means are arranged for recognizing at least a first content of said control bits for subsequently executing an interface reset, and at least a second content of said control bits for thereupon activating an extended addressing operation.

## Patentansprüche

1. Mehrstationskommunikationsbussystem mit einer Master-Station (20) und einer Vielzahl von Slave-Stationen (30, 40), wobei die genannte Master-Station (20) zum separaten Übertragen von Taktsignalen (14), Informationsbitgruppensignalen (16) und Angabesignalen (12) auf drei separaten Leitungen vorgesehen ist, wobei jedes Angabesignal (12) eine tatsächliche Informationsbitgruppe identifiziert, die entweder Adresseninformationen oder Dateninformationen darstellt, dadurch gekennzeichnet, daß eine derartige Adresseninformationsbitgruppe neben den operationellen Adressenbits auch Steuerbits umfaßt, wobei die genannten Slave-Stationen jeweils vorgesehen sind, um folgendes zu erkennen:
* mindestens eine bestimmte entsprechende Adresse als ihre eigene Adresse,
* entsprechende Werte der genannten Steuerbits als eine Richtung für den nachfolgenden Datentransfer in bezug auf einen adressierten Slave anweisend, und
* eine bestimmte operationelle Adresse als ein Schnittstellen-Rücksetzungs-Steuerungssignal.

2. System nach Anspruch 1, wobei die genannte Adressenbitgruppe eine Systemadressenbit-Untergruppe enthält, die sich von einer Geräteadressenbit-Untergruppe unterscheidet.

3. System nach Anspruch 1 oder 2, wobei die genannte Master-Station (20) vorgesehen ist, um das genannte Angabesignal auf den adressenidentifizierenden Wert zum Signalisieren eines "Halte"-Modus zu bringen.

4. System nach Anspruch 1, 2 oder 3, und vorgesehen, um durch die Übertragung eines sekundären Adressenidentifikationscodes einen Adressenprogrammiermodus auszuführen.

5. System nach einem der Ansprüche 1 bis 4, und vorgesehen, um durch das genannte Schnittstellen-Rücksetzungs-Steuerungssignal den genannten Bus zu befreien, um dadurch die Ausführung eines unterschiedlichen und inkompatiblen Bus-Protokolls zu ermöglichen.

6. System nach einem der Ansprüche 1 bis 5, und mit zwei identisch adressierbaren Slave-Stationen, die eine Taktsignalleitung und eine Informationsbitgruppenleitung gemeinsam haben, jedoch jeweils separate Angabeleitungen, die separat mit der genannten Master-Station verbunden sind.

7. System nach einem der Ansprüche 1 bis 6, wobei in einer Adresseninformationsbitgruppe mindestens ein Bit signalisiert, daß eine nachfolgende Informationsbitgruppe zusätzliche Adresseninformationen enthält.

8. Eine Master-Station zur Verwendung in einem System nach einem der Ansprüche 1 bis 5, mit ersten Busleitungs-Zusatzmitteln (24) zum Ausgeben von Taktsignalen, zweiten Busleitungs-Zusatzmitteln (62) zum Kommunizieren von Informationsbitgruppensignalen und dritten Busleistungs-Zusatzmitteln zum Ausgeben von Angabesignalen, wobei jedes Angabesignal eine tatsächliche Informationsbitgruppe entweder als Adresseninformationen oder als Dateninformationen darstellend identifziert, dadurch gekennzeichnet, daß die zweiten Busleitungs-Zusatzmittel vorgesehen sind, um eine Vielzahl von unterschiedlichen Adressen einschließlich mindestens einem operationellen Adressenbit als ein Schnittstellen-Rücksetzungs-Steuerungssignal auszugeben, und dadurch, daß die genannten zweiten Busleitungs-Zusatzmittel vorgesehen sind, um innerhalb einer Adressenbitgruppe mindestens zwei Steuerbits einzufügen, um mit entsprechenden Werten hiervon eine Richtung für den nachfolgenden Datentransfer in bezug auf einen adressierten Slave vorzugeben.

9. Master-Station (20) nach Anspruch 6 und mit "Halte"-Steuerungsmitteln, die mit den genannten dritten Busleitungs-Zusatzmitteln verbunden sind, um durch ihre Adresseninformation den Wert der genannten Angabesignale zu identifizieren, die einen "Haltemodus" signalisieren.

10. Slave-Station (30) zur Verwendung in einem System nach einem der Ansprüche 1 bis 5 oder mit einer Master-Station (20) nach Anspruch 8 oder 9 und mit vierten Busleitungs-Zusatzmitteln zum Empfangen der genannten Taktsignale, fünften Busleitungs-Zusatzmitteln zum Kommunizieren von Informationsbitgruppensignalen und sechsten Busleitungs-Zusatzmitteln zum Empfangen von Angabesignalen und um anhand des Wertes eines derartigen Angabesignals zu erkennen, ob die tatsächlich empfangene Bitgruppe Adresseninformationen oder Dateninformationen darstellt, wobei die fünften Bitleitungs-Zusatzmittel auf die genannte Unterscheidung reagieren, wenn Adresseninformationen vorgesehen sind, um:
* mindestens eine bestimmte entsprechende Adresse als eigene Adresse zu erkennen;
* innerhalb der eine Adresseninformation darstellenden Bitgruppe entsprechende Werte von Nicht-Adressen-Steuerbits als eine Richtung für den nachfolgenden Datentransfer in bezug auf die fünften Busleitungs-Zusatzmittel vorgebend zu erkennen.

11. Slave-Station (30) nach Anspruch 10, wobei die fünften Busleitungs-Zusatzmittel reagieren, um Adresseninformationen zu empfangen und insbesondere einen sekundären Adressenidentifikationscode, um die genannte Slave-Station anschließend in einen Adressenprogrammiermodus zu bringen.

12. Slave-Station (30) nach Anspruch 10 oder 12, wobei die sechsten Busleitungs-Zusatzmittel auf den genannten adressenidentifizierenden Wert reagieren, um bei Abwesenheit von Taktimpulsen auf dem vierten Busleitungs-Zusatzmittel die betreffende Slave-Station in einen "Haltemodus" zu bringen.

13. Slave-Station (30) nach Anspruch 10, 11 oder 12 und vorgesehen für die Programmierbarkeit der operationellen Adresse, wobei die fünften Busleitungs-Zusatzmittel vorgesehen sind, um mindestens einen ersten Inhalt der genannten Steuerbits für die anschließende Ausführung einer Schnittstellen-Rücksetzung zu erkennen und mindestens einen zweiten Inhalt der genannten Steuerbits, um daraufhin eine erweiterte Adressieroperation zu aktivieren.

## Revendications

1. Système de communication à bus à stations multiples recevant une station maîtresse (20) et une pluralité de stations esclaves (30, 40), ladite station maîtresse (20) étant agencée pour transmettre séparément des signaux d'horloge (14), des signaux de groupe de bits d'information (16), et des signaux d'indication (12) sur trois fils séparés respectifs, chaque signal d'indication (12) identifiant un groupe de bits d'information proprement dit comme représentant, soit des informations d'adresse, soit des informations de données, caractérisé en ce qu'un groupe de bits d'information de ce type comprend outre des bits de commande également des bits d'adresse opérationnelle, lesdites stations esclaves étant chacune agencées pour reconnaître :
* au moins une adresse respective particulière comme leur propre adresse;
* des valeurs respectives desdits bits de commande comme demandant un sens de transfert de données suivant par rapport à un esclave adressé, et
* une adresse opérationnelle particulière comme signal de commande de réinitialisation d'interface.

2. Système suivant la revendication 1, dans lequel ledit groupe de bits d'adresse comprend un sous-groupe de bits d'adresse de système sous forme distincte d'un sous-groupe de bits d'adresse de dispositif.

3. Système suivant la revendication 1 ou 2, dans lequel ladite station maîtresse (20) est agencée pour amener ledit signal d'indication à une valeur identifiant l'adresse pour signaler un mode "d'arrêt".

4. Système suivant la revendication 1, 2 ou 3, et étant fourni pour exécuter un mode de programmation d'adresse par le transfert d'un code d'identification d'adresse secondaire.

5. Système suivant l'une quelconque des revendications 1 à 4, et étant fourni pour, par ledit signal de commande de réinitialisation d'interface, libérer ledit bus et recevoir de ce fait l'exécution d'un protocole de bus différent et incompatible.

6. Système suivant l'une quelconque des revendications 1 à 5, et possédant deux stations esclaves adressables de manière identique, qui ont en commun un fil de signal d'horloge et un fil de groupe de bits d'information, mais ont des fils d'indication respectifs séparés, connectés séparément à ladite station maîtresse.

7. Système suivant l'une quelconque des revendications 1 à 6, dans lequel, dans un groupe de bits d'information d'adresse, au moins un bit signale qu'un groupe de bits d'information suivant contient des informations d'adresse supplémentaires.

8. Station maîtresse à utiliser dans un système suivant l'une quelconque des revendications 1 à 5, comportant des premiers moyens de connexion de fils de bus (24) pour produire des signaux d'horloge, des deuxièmes moyens de connexion de fils de bus (62) pour communiquer des signaux de groupe de bits d'information, et des troisièmes moyens de connexion de fils de bus pour produire des signaux d'indication, chaque signal d'indication identifiant un groupe de bits d'information proprement dit comme représentant, soit des informations d'adresse, soit des informations de données, caractérisée en ce que lesdits deuxièmes moyens de connexion de fils de bus sont agencés pour produire une pluralité d'adresses différentes, dont au moins un bit d'adresse opérationnelle comme signal de commande de réinitialisation d'interface, et en ce que lesdits deuxièmes moyens de connexion de fils de bus sont agencés pour insérer, à l'intérieur d'un groupe de bits d'adresse, au moins deux bits de commande afin de demander, avec les valeurs respectives de ceux-ci, un sens de transfert de données suivant par rapport à un esclave adressé.

9. Station maîtresse (20) suivant la revendication 6, et possédant des moyens de commande d'arrêt connectés auxdits troisièmes moyens de connexion de fils de bus pour signaler, par leur valeur identifiant les informations d'adresse desdits signaux d'indication, un mode "d'arrêt".

10. Station esclave (30) destinée à être utilisée dans un système suivant l'une quelconque des revendications 1 à 5, ou avec une station maîtresse (20) suivant la revendication 8 ou 9, et comportant des quatrièmes moyens de connexion de fils de bus pour recevoir lesdits signaux d'horloge, des cinquièmes moyens de connexion de fils de bus pour communiquer des signaux de groupe de bits d'information, et des sixièmes moyens de connexion de fils de bus pour recevoir des signaux d'indication et, par le biais de la valeur d'un signal d'indication de ce type, discriminer un groupe de bits proprement dit reçu comme représentant, soit des informations d'adresse, soit des informations de données, lesdits cinquièmes moyens de connexion de fils de bus réagissant à ladite discrimination lorsque les informations d'adresse sont agencées pour :
* reconnaître au moins une adresse respective particulière comme leur propre adresse, et
* à l'intérieur d'un groupe de bits représentant des informations d'adresse, reconnaître des valeurs respectives de bits de commande sans adresse comme demandant un sens de transfert de données suivant par rapport auxdits cinquièmes moyens de connexion de fils de bus.

11. Station esclave (30) suivant la revendication 10, dans laquelle lesdits cinquièmes moyens de connexion de fil de bus réagissent pour recevoir des informations d'adresse, et en particulier un code d'identification d'adresse secondaire pour ensuite amener ladite station esclave dans un mode de programmation d'adresse.

12. Station esclave (30) suivant la revendication 10 ou 11, dans laquelle lesdits sixièmes moyens de connexion de fil de bus réagissent à ladite valeur identifiant l'adresse pour amener, en l'absence d'impulsions d'horloge sur lesdits quatrièmes moyens de connexion de fil de bus, la station esclave en question dans un mode "d'arrêt".

13. Station esclave (30) suivant la revendication 10, 11 ou 12, et agencée pour une capacité de programmation d'adresse opérationnelle, dans laquelle lesdits cinquièmes moyens de connexion de fil de bus sont agencés pour reconnaître au moins un premier contenu desdits bits de commande pour ensuite exécuter une réinitialisation d'interface, et au moins un deuxième contenu desdits bits de commande pour dès lors activer une opération d'adressage étendu.
